# EUROPÄISCHE PATENTSCHRIFT

(11) **EP 3 207 552 B1**
(45) Veröffentlichungstag und Bekanntmachung des Hinweises auf die Patenterteilung: **23.01.2019**
(21) Anmeldenummer: 15787488.4
(22) Anmeldetag: 12.10.2015
(51) Int. Cl.: H01G 4/32, H01G 4/008

(54) **VERFAHREN ZUR HERSTELLUNG EINES KOMPAKTEN MIKRO- ODER NANO-KONDENSATORS UND KOMPAKTER MIKRO- ODER NANO-KONDENSATOR**
METHOD FOR PRODUCING A COMPACT MICRO- OR NANOCAPACITOR, AND COMPACT MICRO- OR NANOCAPACITOR
PROCÉDÉ POUR LA FABRICATION D'UN MICROCONDENSATEUR OU D'UN NANOCONDENSATEUR COMPACT ET MICROCONDENSATEUR OU NANOCONDENSATEUR COMPACT

(30) Priorität: 13.10.2014 DE 102014220669
(43) Veröffentlichungstag der Anmeldung: 23.08.2017
(73) Patentinhaber: Leibniz-Institut für Festkörper- und Werkstoffforschung Dresden e.V., 01069 Dresden (DE)
(72) Erfinder: SCHMIDT, Oliver G., 01219 Dresden (DE)
(74) Vertreter: Rauschenbach, Marion
(86) Internationale Anmeldenummer: PCT/EP2015/073540
(87) Internationale Veröffentlichungsnummer: WO 2016/058980

(56) Entgegenhaltungen:
- US-A1- 2005 118 733
- US-A1- 2012 140 379
- US-A1- 2014 103 486
- US-A1- 2014 147 473
- BOF BUFON C C ET AL: "Self-assembled ultra-compact energy storage elements based on hybrid nanomembranes", NANO LETTERS, Bd. 10, Nr. 7, 14. Juli 2010 (2010-07-14), Seiten 2506-2510, XP002752130, AMERICAN CHEMICAL SOCIETY USA DOI: 10.1021/NL1010367 in der Anmeldung erwähnt

## Beschreibung

Die Erfindung bezieht sich auf die Gebiete der Mikroelektronik und der Materialwissenschaften und betrifft ein Verfahren zur Herstellung eines kompakten Mikro- oder Nano-Kondensators und einen kompakten Mikro- oder Nano-Kondensator, wie er beispielsweise in elektrischen und elektronischen Geräten als Bauelement für frequenz- und zeitbestimmende Anwendungen sowie in Hochfrequenz-Schwingkreisen und -filtern zum Einsatz kommen kann.

Unsere elektronisch mobile Gesellschaft fordert immer neue Errungenschaften/Verbesserungen, um kompakte integrative Bauelemente für die mobile Benutzung unterwegs komfortabel nutzen zu können. Mit der fortschreitenden Miniaturisierung der letzten Jahrzehnte, speziell in der digitalen Elektronik, müssen auch die in der Peripherie der integrierten Logikschaltungen benötigten Bauelemente immer kleiner werden. Eine besondere Bedeutung kommt dabei kompakten Kondensatorelementen in Mikro- oder Nanometerabmessungen zu.

Abmessungen im Mikrometerbereich sollen dabei im Rahmen dieser Erfindung Objekte sein, deren Hauptbestandteil mehrheitlich und mindestens entlang einer der drei Achsen eine Größe von 0,1 bis 500 Mikrometern aufweisen und im Nanometerbereich eine Größe von 1 bis 100 Nanometern (Definition EU-Kommission).

Bei der Roll-up-Technologie werden Schichten auf ein Substrat aufgebracht und nachfolgend aufgerollt. Der Mechanismus des Aufrollens kann durch Aufbringen der Schichten in einem Verspannungszustand und nachfolgendes Entspannen oder durch Aufbringen und nachfolgendes Entfernen einer Opferschicht realisiert werden (Y. Mei et al: Advanced Materials, 2008, 20; O.G. Schmidt und K. Eberl: Nature 2001, 410).

Gemäß Bufon sind ebenfalls Kondensator-Schichtaufbauten bekannt, die auf einer Opferschicht angeordnet sind und durch Entfernen der Opferschicht aufgerollt werden. Der Durchmesser der Kondensatoren beträgt > 10 µm. [C.C.B. Bufon et al., Nano Letters, 2010, 10, 2506-2510].

Nachteilig an dem bekannten Stand der Technik ist, dass die Herstellung aufgerollter Bauelemente nach wie vor technologisch schwierig ist. Dies insbesondere deshalb, da immer mehr Windungen bei immer kleineren Durchmessern gewünscht sind, um immer kompaktere Bauelemente mit Mikro- oder Nanometerabmessungen herstellen zu können, was immer höhere Anforderungen an die Dünnschichten hinsichtlich ihrer mechanischen Eigenschaften stellt. Ebenso wird die Kontaktierung der Funktionsschichten innerhalb eines solchen ultrakompakten Bauelementes gerade bei Mikro- oder Nanometerabmessungen immer schwieriger realisierbar, da mit zunehmender Rolllänge der Schichten die Länge der Kontaktierungen wächst und somit auch ihr Widerstand. Hinzu kommt, dass insbesondere durch die Kontaktierungsmaterialien die Dicke der Bauelemente unerwünschterweise anwächst.

Die Aufgabe der vorliegenden Erfindung besteht in der Angabe eines einfachen und kostengünstigen Verfahrens zur Herstellung eines kompakten Mikro- oder Nano-Kondensators, der eine zuverlässige und einfache Kontaktierung der Funktionsschichten aufweist.

Die Aufgabe wird durch die in den Ansprüchen angegebene Erfindung gelöst. Vorteilhafte Ausgestaltungen sind Gegenstand der Unteransprüche.

Bei dem erfindungsgemäßen Verfahren zur Herstellung eines kompakten Mikro- oder Nano-Kondensators wird auf einem Substrat ein Schichtstapel hergestellt, der in der Reihenfolge aus mindestens zwei Funktionsschichten und aus jeweils darauf angeordneter mindestens einer Schicht aus einem zweidimensionalen Material besteht und aus mindestens zwei Schichten aus einem elektrisch isolierenden Material, die zwischen den jeweils mindestens zwei Funktionsschichten mit den mindestens zwei Schichten aus einem zweidimensionalen Material zur elektrischen Isolierung angeordnet werden, wobei die Schichten aus einem zweidimensionalen Material mindestens teilweise einen stoffschlüssigen Kontakt mit den Funktionsschichten aufweisen, oder ein Schichtstapel aus mindestens zwei Schichten aus einem zweidimensionalen Material und aus mindestens zwei Schichten aus einem elektrisch isolierenden Material hergestellt wird, wobei zwischen die mindestens zwei Schichten aus einem zweidimensionalen Material mindestens eine Schicht aus einem elektrisch isolierenden Material zur elektrischen Isolierung angeordnet wird, und wobei die mindestens eine Funktionsschicht mit der Schicht aus einem zweidimensionalen Material oder die eine Schicht aus einem zweidimensionalen Material im Wesentlichen quer zur Aufrollrichtung auf einer Seite über die Breite des Schichtstapels hinausreichend angeordnet wird, und die mindestens zweite Funktionsschicht mit der zweiten Schicht aus einem zweidimensionalen Material oder die zweite Schicht aus einem zweidimensionalen Material im Wesentlichen quer zur Aufrollrichtung auf der anderen Seite über die Breite des Schichtstapels hinausreichend angeordnet wird, und nachfolgend der Schichtstapel auf dem Substrat aufgerollt wird und die über die Breite des aufgerollten Bauelementes jeweils spiralförmig hinausreichenden Schichten mindestens teilweise stoffschlüssig miteinander verbunden und mit elektrischen Anschlüssen kontaktiert werden.

Vorteilhafterweise wird der Schichtstapel auf dem Substrat verspannt angeordnet, wobei vorteilhafterweise der Verspannungsgradient des Schichtstapels senkrecht zur Substratoberfläche ausgerichtet wird, und nachfolgend der Schichtstapel aufgerollt wird.

Weiterhin vorteilhafterweise wird auf das Substrat eine Opferschicht aufgebracht und nachfolgend der Schichtstapel auf die Opferschicht angeordnet und nachfolgend die Opferschicht mindestens teilweise entfernt.

Ebenfalls vorteilhafterweise wird das Aufrollen der Schichtstapel in einer Flüssigkeit durchgeführt und nachfolgend der aufgerollte Schichtstapel getrocknet, wobei noch vorteilhafterweise das Aufrollen der Schichtstapel in einer Flüssigkeit aus Wasser oder einer wässrigen Lösung oder einem Lösungsmittel oder Lösungsmittelgemisch durchgeführt wird, und wobei auch noch vorteilhafterweise das Trocknen der aufgerollten Schichtstapel bei Temperaturen von 15 °C bis 400°C durchgeführt wird.

Und auch vorteilhafterweise werden die zusammenkontaktierten zweidimensionalen Materialien mit Nickel oder Kupfer mit den elektrischen Anschlüssen kontaktiert.

Der erfindungsgemäße kompakte Mikro- oder Nano-Kondensator, der nach dem erfindungsgemäßen Verfahren hergestellt worden ist, besteht aus mindestens zwei Funktionsschichten mit jeweils mindestens einer Schicht aus einem zweidimensionalen Material, die mindestens teilweise einen stoffschlüssigen Kontakt mit den Funktionsschichten aufweisen, und aus mindestens zwei Schichten aus einem elektrisch isolierenden Material oder aus mindestens zwei Schichten aus einem zweidimensionalen Material und aus mindestens zwei Schichten aus einem elektrisch isolierenden Material, wobei die Funktionsschichten mit den Schichten aus einem zweidimensionalen Material oder die Schichten aus einem zweidimensionalen Material durch die Schichten aus einem elektrisch isolierenden Material jeweils elektrisch isolierend getrennt voneinander angeordnet sind, und diese übereinander angeordneten Schichten aufgerollt sind und die mindestens eine Funktionsschicht mit der mindestens einen Schicht aus einem zweidimensionalen Material oder die mindestens eine Schicht aus einem zweidimensionalen Material im Wesentlichen quer zur Aufrollrichtung auf einer Seite mit mindestens 5 % ihrer Gesamtbreite über die Breite des aufgerollten Schichtstapels hinausreichend angeordnet ist, und die mindestens zweite Funktionsschicht mit der mindestens zweiten Schicht aus einem zweidimensionalen Material oder die mindestens zweite Schicht aus einem zweidimensionalen Material im Wesentlichen quer zur Aufrollrichtung auf der anderen Seite mit mindestens 5 % ihrer Gesamtbreite über die Breite des aufgerollten Schichtstapels hinausreichend angeordnet ist, und auf jeder Seite des aufgerollten Schichtstapels alle spiralförmig hinausreichenden Funktionsschichten mit der mindestens einen Schicht aus einem zweidimensionalen Material oder die mindestens eine Schicht aus einem zweidimensionalen Material mindestens teilweise stoffschlüssig miteinander verbunden und elektrisch kontaktiert sind.

Es ist vorteilhaft, wenn die Mikro- oder Nano-Kondensatoren aufgerollt einen äußeren Durchmesser von maximal 200 µm aufweisen.

Vorteilhafterweise ist als zweidimensionales Material Graphen vorhanden.

Weiterhin vorteilhafterweise ist als Funktionsschicht ein elektrisch leitendes Material, wie Kupfer oder Nickel vorhanden.

Ebenfalls vorteilhafterweise ist als elektrisch isolierendes Material Al₂O₃ oder TiO₂ vorhanden.

Von Vorteil ist es auch, wenn die Funktionsschichten mit den Schichten aus einem zweidimensionalen Material oder die Schichten aus einem zweidimensionalen Material im Wesentlichen quer zur Aufrollrichtung auf jeweils einer Seite mit mindestens 5 - 30 % ihrer Gesamtbreite über die Breite des aufgerollten Schichtstapels hinausreichend angeordnet sind.

Vorteilhaft ist es auch, wenn ein aufgerollter Schichtstapel aus einer Funktionsschicht, darüber angeordnet einer Schicht aus einem zweidimensionalen Material, darüber angeordnet einer Schicht aus einem elektrisch isolierenden Material, darüber angeordnet einer weiteren Funktionsschicht, darüber angeordnet einer weiteren Schicht aus einem zweidimensionalen Material, darüber angeordnet eine weiteren Schicht aus einem elektrisch isolierenden Material realisiert ist,
oder ein aufgerollter Schichtstapel aus einer Schicht aus einem elektrisch isolierenden Material, darüber angeordnet eine Funktionsschicht darüber angeordnet eine Schicht aus einem zweidimensionalen Material, darüber angeordnet eine weitere Schicht aus einem elektrisch isolierenden Material, darüber angeordnet eine weitere Funktionsschicht darüber angeordnet eine weitere Schicht aus einem zweidimensionalen Material realisiert ist.

Ebenfalls vorteilhaft ist es, wenn ein aufgerollter Schichtstapel aus einer Schicht aus einem zweidimensionalen Material, darüber angeordnet einer Schicht aus einem elektrisch isolierenden Material, darüber angeordnet einer weiteren Schicht aus einem zweidimensionalen Material, darüber angeordnet eine weiteren Schicht aus einem elektrisch isolierenden Material realisiert ist,
oder ein aufgerollter Schichtstapel aus einer Schicht aus einem elektrisch isolierenden Material, darüber angeordnet eine Schicht aus einem zweidimensionalen Material, darüber angeordnet eine weitere Schicht aus einem elektrisch isolierenden Material, darüber angeordnet eine weitere Schicht aus einem zweidimensionalen Material realisiert ist.

Weiterhin vorteilhaft ist es, wenn die Schichten aus dem zweidimensionalen Material mit den Funktionsschichten in vollständigem stoffschlüssigen Kontakt stehen.

Und auch vorteilhaft ist es, wenn die Schichten aus dem zweidimensionalen Material eine Dicke von ≤ 5, noch vorteilhafterweise 1 bis 2, atomaren Lagen aufweisen.

Von Vorteil ist es auch, wenn die Schichten aus dem zweidimensionalen Material ganz oder teilweise auf den Funktionsschichten aufgewachsen angeordnet sind.

Mit der erfindungsgemäßen Lösung wird es erstmals möglich, ein einfaches und kostengünstiges Verfahren zur Herstellung eines kompakten Mikro- oder Nano-Kondensators anzugeben. Ebenso wird es erstmals möglich, einen kompakten Mikro- oder Nano-Kondensator anzugeben, der eine zuverlässige und einfache Kontaktierung der Funktionsschichten aufweist.

Erreicht wird dies durch ein Verfahren zur Herstellung eines kompakten Mikro- oder Nano-Kondensators, bei dem im Wesentlichen ein aufgerollter Schichtstapel aus mindestens zwei Funktionsschichten mit jeweils mindestens einer Schicht aus einem zweidimensionalen Material und aus mindestens zwei Schichten aus einem elektrisch isolierenden Material oder aus mindestens zwei Schichten aus einem zweidimensionalen Material und aus mindestens zwei Schichten aus einem elektrisch isolierenden Material hergestellt wird, wobei die Schichten aus einem zweidimensionalen Material im stoffschlüssigen Kontakt mit den Funktionsschichten stehen und gleichzeitig die mindestens eine Funktionsschicht mit der mindestens einen Schicht aus einem zweidimensionalen Material oder die mindestens eine Schicht aus einem zweidimensionalen Material im Wesentlichen quer zur Aufrollrichtung auf einer Seite mit mindestens 5 % ihrer Gesamtbreite über die Breite des aufgerollten Schichtstapels hinausreichend angeordnet ist, und die mindestens zweite Funktionsschicht mit der mindestens zweiten Schicht aus einem zweidimensionalen Material oder die mindestens zweite Schicht aus einem zweidimensionalen Material im Wesentlichen quer zur Aufrollrichtung auf der anderen Seite mit mindestens 5 % ihrer Gesamtbreite über die Breite des aufgerollten Schichtstapels hinausreichend angeordnet ist und damit die mindestens zwei Funktionsschichten und/oder die mindestens zwei Schichten aus einem zweidimensionalen Material getrennt voneinander für eine elektrisch leitendende Kontaktierung zugänglich machen.
Die Bereiche der Schichten, die über die Gesamtbreite des aufgerollten Schichtstapels hinausreichen, können jeweils mit 5 bis 30 % ihrer Gesamtbreite auf jeder Seite über die Gesamtbreite des aufgerollten Schichtstapels hinausreichen. Insgesamt oder auch bei einem nicht vollständig gleichmäßigen Aufrollen des Schichtstapels kann die Breite der hinausragenden Schichtbereiche auf jeder Seite auch unterschiedlich groß sein.
Gleichzeitig sind die Bereiche der mindestens zwei Funktionsschichten und/oder die mindestens zwei Schichten aus einem zweidimensionalen Material, die über die Gesamtbreite des aufgerollten Schichtstapels auf jeder Seite hinausreichen mindestens teilweise stoffschlüssig miteinander verbunden und werden dann elektrisch kontaktiert. Diese stoffschlüssige Verbindung der hinausragenden Bereiche der Schichten erfolgt während und/oder nach dem Aufrollen der Schichten ohne weitere Aktivitäten oder Hilfsmittel aufgrund der geringen Abmessungen der Schichtdicken und des Durchmessers des aufgerollten Schichtstapels. Damit sind die spiralförmig herausragenden Schichtbereiche gleich elektrisch miteinander verbunden und können einfacher elektrisch kontaktiert werden.

Auf diese Art und Weise werden lange Kontaktierungen vermieden und deren Widerstände klein gehalten.

Dabei ist von besonderer Bedeutung, dass derartige zweidimensionale Materialien extrem dünn sind, sie weiterhin gut elektrisch leitfähig sind, und auch eine ausreichend gute Elastizität und mechanische Stabilität aufweisen. Alle diese Eigenschaften weisen beispielsweise Graphenschichten auf.
Sie weisen weiterhin den Vorteil auf, dass derartige Graphenschichten auf metallischen Funktionsschichten aufwachsen können und daher besonders dünn, vorteilhafterweise in nur einer oder wenigen Atomlagen Dicke, vorteilhafterweise ≤ 5 Atomlagen Dicke, realisiert werden können. Vorteilhafterweise werden die Schichten aus dem zweidimensionalen Material, wie die Graphenschichten in nur einer bis zwei Atomlagen aufgebracht.

Ein Schichtaufbau des erfindungsgemäßen kompakten elektrischen oder elektronischen Bauelementes mit Mikro- oder Nano-Abmessungen könnte folgendermaßen aussehen:
eine Funktionsschicht, darüber angeordnet eine Schicht aus einem zweidimensionalen Material, darüber angeordnet eine Schicht aus einem elektrisch isolierenden Material, darüber angeordnet eine weitere Funktionsschicht darüber angeordnet eine weitere Schicht aus einem zweidimensionalen Material, darüber angeordnet ein weitere Schicht aus einem elektrisch isolierenden Material;
oder
eine Schicht aus einem elektrisch isolierenden Material, darüber angeordnet eine Funktionsschicht darüber angeordnet eine Schicht aus einem zweidimensionalen Material, darüber angeordnet eine weitere Schicht aus einem elektrisch isolierenden Material, darüber angeordnet eine weitere Funktionsschicht darüber angeordnet eine weitere Schicht aus einem zweidimensionalen Material.

Ebenso kann anstelle der Funktionsschicht und der zweidimensionalen Schicht nur jeweils eine Schicht aus einem zweidimensionalen Material angeordnet sein, da dieses elektrisch leitfähig ist und die Funktion der Funktionsschicht im erfindungsgemäßen kompakten Kondensator einnehmen kann.

Weiterhin von besonderer Bedeutung ist, dass die Schichten aus dem zweidimensionalen Material über die Breite des Schichtstapels hinausreichen. Dabei kann dies direkt quer zur Aufrollrichtung oder auch in einem Winkel realisiert sein. Gesichert sein muss, dass nach dem Aufrollen des Schichtstapels die mindestens beiden Schichten aus dem zweidimensionalen Material an je einer Seite des aufgerollten Bauelementes soweit hinausragen, das sie elektrisch kontaktiert werden können. Dies wird gesichert, in dem die jeweiligen Schichten auf jeder Seite mit mindestens 5 % ihrer Gesamtbreite über die Gesamtbreite des aufgerollten Schichtstapels hinausragen. Ebenso muss gesichert sein, dass die mindestens zwei Schichten aus einem zweidimensionalen Material keinen elektrisch leitenden Kontakt zueinander aufweisen. Dies wird erreicht, indem die jeweils mindestens erste Funktionsschicht mit der mindestens ersten Schicht aus einem zweidimensionalen Material oder die mindestens erste Schicht aus einem zweidimensionalen Material auf der einen Seite über die Gesamtbreite des aufgerollten Schichtstapels hinausragen, und die jeweils zweiten Funktionsschichten mit den mindestens zweiten Schichten aus einem zweidimensionalen Material oder die mindestens zweiten Schichten aus einem zweidimensionalen Material auf der anderen Seite über die Gesamtbreite des aufgerollten Schichtstapels hinausragen.

Ebenfalls ist von besonderer Bedeutung, dass aufgrund der guten elastischen und mechanischen Eigenschaften der zweidimensionalen Materialien diese beim Aufrollprozess nicht ab- und/oder einreißen und gut elektrisch leitend kontaktierbar sind.

Der Aufrollprozess kann realisiert werden, indem auf das Substrat eine Opferschicht aufgebracht wird, darauf der Schichtstapel für das erfindungsgemäße Bauelement und durch mindestens teilweises Entfernen der Opferschicht das Aufrollen des Schichtstapels ausgelöst wird. Ebenso ist es möglich, dass der Schichtstapel für das erfindungsgemäße Bauelement in verspannter Art und Weise auf das Substrat aufgebracht wird, wobei vorteilhafterweise der Verspannungsgradient des Schichtstapels senkrecht zur Substratoberfläche ausgerichtet wird, und durch Lösen der Verspannung das Aufrollen des Schichtstapels ausgelöst wird.

Der Aufrollprozess wird vorteilhafterweise in einer Flüssigkeit durchgeführt, die beispielsweise Wasser oder eine wässrige Lösung oder ein Lösungsmittel oder ein Lösungsmittelgemisch sein kann. Im Falle des Aufrollens in einer Flüssigkeit muss der aufgerollte Schichtstapel getrocknet werden, was vorteilhafterweise bei Temperaturen zwischen 15 °C und 400 °C durchgeführt wird.

Das Aufrollen des Schichtstapels in Flüssigkeit mit nachfolgender Trocknung hat den Vorteil, dass ein relativ gleichmäßiges gerades Aufrollen des Schichtstapels erfolgt und durch das Trocknen der aufgerollte Schichtstapel gleichzeitig eine verbesserte mechanische Stabilität zeigt.

Als erfindungsgemäße elektrische oder elektronische Bauelemente können die kompakten Mikro- und Nano-Kondensatoren mit Abmessungen von vorteilhafterweise 100 nm bis zu 200 µm Breite und Durchmessern von 50 nm bis 100 µm hergestellt werden. Der Markt für derartige Kondensatoren ist >5 Mrd. €.

Nachfolgend wird die Erfindung an einem Ausführungsbeispiel näher erläutert.

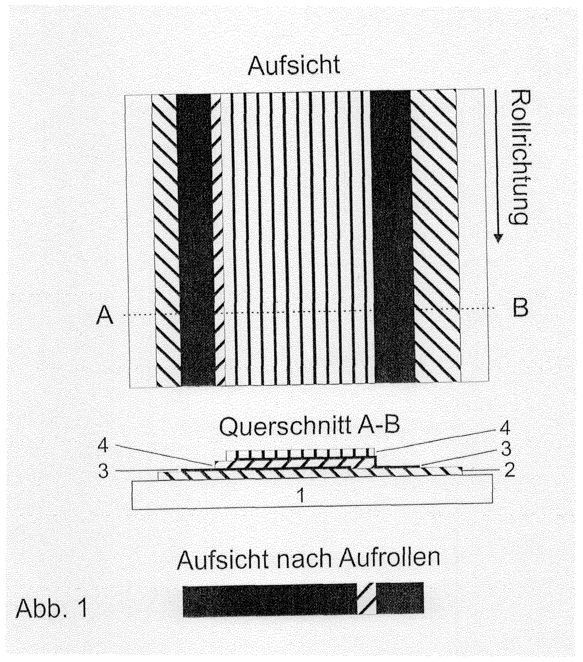

Dabei zeigt
- Fig. 1: eine Darstellung eines Schichtstapels für das erfindungsgemäße Bauelement

### Beispiel

Auf einem Substrat aus Silizium wird eine Opferschicht aus einem Polymer aufgebracht. Darauf wird eine Funktionsschicht aus Kupfer mit einer Dicke von 10 nm mittels thermischen Verdampfens aufgebracht. Auf der Oberfläche der Funktionsschicht wird mittels Gasphasenabscheidung (Chemical Vapor Deposition (CVD)) eine Schicht aus Graphen als Schicht aus einem zweidimensionalen Material mit einer Dicke von einer atomaren Lage aufgewachsen, wobei die Funktionsschicht und die Graphenschicht über den rechten Rand in Aufrollrichtung über die später abzuscheidenden Al₂O₃-Schichten hinaus auf der Opferschicht positioniert werden. Nachfolgend wird eine Schicht aus Al₂O₃ mittels Atomlagenabscheidung (Atomic Layer Deposition (ALD)) mit einer Dicke von 10 nm über die Funktionsschicht und Graphenschicht aufgebracht, wobei am rechten Rand in Aufrollrichtung ein Streifen der Graphenschicht nicht mit der Al₂O₃-Schicht beschichtet wird. Danach wird eine zweite Funktionsschicht aus Kupfer mittels thermischen Verdampfens über der Schicht aus Al₂O₃ aufgebracht, und auf dieser zweiten Funktionsschicht wird eine zweite Graphenschicht mittels CVD aufgewachsen, wobei die zweite Funktionsschicht und die zweite Graphenschicht über den linken Rand in Aufrollrichtung über die Al₂O₃-Schichten hinaus auf der Opferschicht angeordnet werden. Darauf wird eine zweite Schicht aus Al₂O₃ mittels ALD aufgebracht, wobei am linken Rand in Aufrollrichtung ein Streifen der Graphenschicht nicht mit der Al₂O₃-Schicht beschichtet wird. Die jeweils zweiten Schichten weisen die gleiche Dicke, wie die jeweils ersten Schichten auf.
Der aufgerollte Schichtstapel ohne die herausragenden Schichtbereiche weist eine Breite von 50 µm auf und eine Dicke von 20 µm.

Nachfolgend wird die Opferschicht durch Wasser entfernt und der Schichtstapel rollt sich in fünf Minuten auf.
Die nun an beiden Seiten der Breite des aufgerollten Schichtstapels hinausragenden Funktionsschichten mit den Graphenschichten werden mit Kupfer kontaktiert und in ein Gehäuse verpackt.

Auf diese Art und Weise ist einfach und kostengünstig ein kompakter Mikro- oder Nano-Kondensator hergestellt worden, der eine zuverlässige und einfache Kontaktierung der Funktionsschichten aufweist.

### Bezugszeichenliste

- 1: Substrat
- 2: Opferschicht
- 3: Funktionsschicht mit zweidimensionaler Schicht
- 4: Isolationsschicht

## Patentansprüche

1. Verfahren zur Herstellung eines kompakten Mikro- oder Nano-Kondensators, bei dem auf einem Substrat ein Schichtstapel hergestellt wird, der in der Reihenfolge aus mindestens zwei Funktionsschichten und aus jeweils darauf angeordneter mindestens einer Schicht aus einem zweidimensionalen Material besteht und aus mindestens zwei Schichten aus einem elektrisch isolierenden Material, die zwischen den jeweils mindestens zwei Funktionsschichten mit den mindestens zwei Schichten aus einem zweidimensionalen Material zur elektrischen Isolierung angeordnet werden, wobei die Schichten aus einem zweidimensionalen Material mindestens teilweise einen stoffschlüssigen Kontakt mit den Funktionsschichten aufweisen, oder ein Schichtstapel aus mindestens zwei Schichten aus einem zweidimensionalen Material und aus mindestens zwei Schichten aus einem elektrisch isolierenden Material hergestellt wird, wobei zwischen die mindestens zwei Schichten aus einem zweidimensionalen Material mindestens eine Schicht aus einem elektrisch isolierenden Material zur elektrischen Isolierung angeordnet wird, und wobei die mindestens eine Funktionsschicht mit der Schicht aus einem zweidimensionalen Material oder die eine Schicht aus einem zweidimensionalen Material im Wesentlichen quer zur Aufrollrichtung auf einer Seite über die Breite des Schichtstapels hinausreichend angeordnet wird, und die mindestens zweite Funktionsschicht mit der zweiten Schicht aus einem zweidimensionalen Material oder die zweite Schicht aus einem zweidimensionalen Material im Wesentlichen quer zur Aufrollrichtung auf der anderen Seite über die Breite des Schichtstapels hinausreichend angeordnet wird, und nachfolgend der Schichtstapel auf dem Substrat aufgerollt wird und die über die Breite des aufgerollten Bauelementes jeweils spiralförmig hinausreichenden Schichten mindestens teilweise stoffschlüssig miteinander verbunden und mit elektrischen Anschlüssen kontaktiert werden.

2. Verfahren nach Anspruch 1, bei dem der Schichtstapel auf dem Substrat verspannt angeordnet wird, wobei vorteilhafterweise der Verspannungsgradient des Schichtstapels senkrecht zur Substratoberfläche ausgerichtet wird, und nachfolgend der Schichtstapel aufgerollt wird.

3. Verfahren nach Anspruch 1, bei dem auf das Substrat eine Opferschicht aufgebracht und nachfolgend der Schichtstapel auf die Opferschicht angeordnet wird und nachfolgend die Opferschicht mindestens teilweise entfernt wird.

4. Verfahren nach Anspruch 1, bei dem das Aufrollen der Schichtstapel in einer Flüssigkeit, vorteilhafterweise in einer Flüssigkeit aus Wasser oder einer wässrigen Lösung oder einem Lösungsmittel oder Lösungsmittelgemisch, durchgeführt und nachfolgend der aufgerollte Schichtstapel getrocknet wird, wobei vorteilhafterweise das Trocknen der aufgerollten Schichtstapel bei Temperaturen von 15 °C bis 400°C durchgeführt wird..

5. Verfahren nach Anspruch 1, bei dem die zusammenkontaktierten zweidimensionalen Materialien mit Nickel oder Kupfer mit den elektrischen Anschlüssen kontaktiert werden.

6. Kompakter Mikro- oder Nano-Kondensator, hergestellt nach einem Verfahren gemäß Anspruch 1, welche aus mindestens zwei Funktionsschichten mit jeweils mindestens einer Schicht aus einem zweidimensionalen Material, die mindestens teilweise einen stoffschlüssigen Kontakt mit den Funktionsschichten aufweisen, und aus mindestens zwei Schichten aus einem elektrisch isolierenden Material oder aus mindestens zwei Schichten aus einem zweidimensionalen Material und aus mindestens zwei Schichten aus einem elektrisch isolierenden Material bestehen, wobei die Funktionsschichten mit den Schichten aus einem zweidimensionalen Material oder die Schichten aus einem zweidimensionalen Material durch die Schichten aus einem elektrisch isolierenden Material jeweils elektrisch isolierend getrennt voneinander angeordnet sind, und diese übereinander angeordneten Schichten aufgerollt sind und die mindestens eine Funktionsschicht mit der mindestens einen Schicht aus einem zweidimensionalen Material oder die mindestens eine Schicht aus einem zweidimensionalen Material im Wesentlichen quer zur Aufrollrichtung auf einer Seite mit mindestens 5 % ihrer Gesamtbreite über die Breite des aufgerollten Schichtstapels hinausreichend angeordnet ist, und die mindestens zweite Funktionsschicht mit der mindestens zweiten Schicht aus einem zweidimensionalen Material oder die mindestens zweite Schicht aus einem zweidimensionalen Material im Wesentlichen quer zur Aufrollrichtung auf der anderen Seite mit mindestens 5 % ihrer Gesamtbreite über die Breite des aufgerollten Schichtstapels hinausreichend angeordnet sind, und auf jeder Seite der aufgerollten Schichtstapels alle spiralförmig hinausreichenden Funktionsschichten mit der mindestens einen Schicht aus einem zweidimensionalen Material oder die mindestens eine Schicht aus einem zweidimensionalen Material mindestens teilweise stoffschlüssig miteinander verbunden und elektrisch kontaktiert sind.

7. Kompakter Mikro- oder Nano-Kondensator nach Anspruch 6, bei dem die Kondensatoren aufgerollt einen äußeren Durchmesser von maximal 200 µm aufweisen.

8. Kompakter Mikro- oder Nano-Kondensator nach Anspruch 6, bei dem als zweidimensionales Material Graphen vorhanden ist.

9. Kompakter Mikro- oder Nano-Kondensator nach Anspruch 6, bei dem als Funktionsschicht ein elektrisch leitendes Material, wie Kupfer oder Nickel, vorhanden ist.

10. Kompakter Mikro- oder Nano-Kondensator nach Anspruch 6, bei dem als elektrisch isolierendes Material Al₂O₃ oder TiO₂ vorhanden ist.

11. Kompakter Mikro- oder Nano-Kondensator nach Anspruch 6, bei dem die Funktionsschichten mit den Schichten aus einem zweidimensionalen Material oder die Schichten aus einem zweidimensionalen Material im Wesentlichen quer zur Aufrollrichtung auf jeweils einer Seite mit mindestens 5 - 30 % ihrer Gesamtbreite über die Breite des aufgerollten Schichtstapels hinausreichend angeordnet sind.

12. Kompakter Mikro- oder Nano-Kondensator nach Anspruch 6, bei dem ein aufgerollter Schichtstapel aus einer Funktionsschicht, darüber angeordnet einer Schicht aus einem zweidimensionalen Material, darüber angeordnet einer Schicht aus einem elektrisch isolierenden Material, darüber angeordnet einer weiteren Funktionsschicht, darüber angeordnet einer weiteren Schicht aus einem zweidimensionalen Material, darüber angeordnet eine weiteren Schicht aus einem elektrisch isolierenden Material realisiert ist,
oder ein aufgerollter Schichtstapel aus einer Schicht aus einem elektrisch isolierenden Material, darüber angeordnet eine Funktionsschicht darüber angeordnet eine Schicht aus einem zweidimensionalen Material, darüber angeordnet eine weitere Schicht aus einem elektrisch isolierenden Material, darüber angeordnet eine weitere Funktionsschicht darüber angeordnet eine weitere Schicht aus einem zweidimensionalen Material realisiert ist.

13. Kompakter Mikro- oder Nano-Kondensator nach Anspruch 6, bei dem ein aufgerollter Schichtstapel aus einer Schicht aus einem zweidimensionalen Material, darüber angeordnet einer Schicht aus einem elektrisch isolierenden Material, darüber angeordnet einer weiteren Schicht aus einem zweidimensionalen Material, darüber angeordnet eine weiteren Schicht aus einem elektrisch isolierenden Material realisiert ist,
oder ein aufgerollter Schichtstapel aus einer Schicht aus einem elektrisch isolierenden Material, darüber angeordnet eine Schicht aus einem zweidimensionalen Material, darüber angeordnet eine weitere Schicht aus einem elektrisch isolierenden Material, darüber angeordnet eine weitere Schicht aus einem zweidimensionalen Material realisiert ist.

14. Kompakter Mikro- oder Nano-Kondensator nach Anspruch 6, bei dem nur zwei Funktionsschichten mit zwei Schichten aus eine zweidimensionalen Material und zwei Schichten aus einem elektrisch isolierenden Material vorhanden sind, oder bei dem nur zwei Schichten aus eine zweidimensionalen Material und zwei Schichten aus einem elektrisch isolierenden Material vorhanden sind.

15. Kompakter Mikro- oder Nano-Kondensator nach Anspruch 6, bei dem die Schichten aus dem zweidimensionalen Material mit den Funktionsschichten in vollständigem stoffschlüssigen Kontakt stehen und/oder die Schichten aus dem zweidimensionalen Material ganz oder teilweise auf den Funktionsschichten aufgewachsen angeordnet sind..

16. Kompakter Mikro- oder Nano-Kondensator nach Anspruch 6, bei dem die Schichten aus dem zweidimensionalen Material eine Dicke von ≤ 5, vorteilhafterweise 1 bis 2, atomaren Lagen aufweisen.

## Claims

1. Method for producing a compact micro- or nanocapacitor, wherein a layer stack is produced on a substrate, which layer stack consists in order of at least two functional layers and of, respectively arranged thereon, at least one layer composed of a two-dimensional material, and of at least two layers composed of an electrically insulating material, which are arranged for electrical insulation between the respectively at least two functional layers with the at least two layers composed of a two-dimensional material, wherein the layers composed of a two-dimensional material at least partly have a cohesive contact with the functional layers, or a layer stack is produced from at least two layers composed of a two-dimensional material and from at least two layers composed of an electrically insulating material, wherein at least one layer composed of an electrically insulating material is arranged for electrical insulation between the at least two layers composed of a two-dimensional material, and wherein the at least one functional layer with the layer composed of a two-dimensional material or the one layer composed of a two-dimensional material is arranged in a manner extending beyond the width of the layer stack substantially transversely with respect to the roll-up direction on one side, and the at least second functional layer with the second layer composed of a two-dimensional material or the second layer composed of a two-dimensional material is arranged in a manner extending beyond the width of the layer stack substantially transversely with respect to the roll-up direction on the other side, and then the layer stack is rolled up on the substrate and the layers extending in each case spirally beyond the width of the rolled-up component are at least partly cohesively connected to one another and contacted with electrical connections.

2. Method according to Claim 1, wherein the layer stack is arranged on the substrate in a strained manner, wherein the strain gradient of the layer stack is advantageously aligned perpendicular to the substrate surface, and then the layer stack is rolled up.

3. Method according to Claim 1, wherein a sacrificial layer is applied on the substrate and then the layer stack is arranged on the sacrificial layer and then the sacrificial layer is at least partly removed.

4. Method according to Claim 1, wherein the roll-up of the layer stack is carried out in a liquid, advantageously in a liquid composed of water or an aqueous solution or a solvent or solvent mixture, and then the rolled-up layer stack is dried, wherein the drying of the rolled-up layer stacks is advantageously carried out at temperatures of 15°C to 400°C.

5. Method according to Claim 1, wherein the two-dimensional materials contacted together, with nickel or copper, are contacted with the electrical connections.

6. Compact micro- or nanocapacitor, produced according to a method according to Claim 1, which consist of at least two functional layers with respectively at least one layer composed of a two-dimensional material, which at least partly have a cohesive contact with the functional layers, and of at least two layers composed of an electrically insulating material or of at least two layers composed of a two-dimensional material and of at least two layers composed of an electrically insulating material, wherein the functional layers with the layers composed of a two-dimensional material or the layers composed of a two-dimensional material are arranged such that they are separated from one another respectively in an electrically insulating manner by the layers composed of an electrically insulating material, and these layers arranged one above another are rolled up and the at least one functional layer with the at least one layer composed of a two-dimensional material or the at least one layer composed of a two-dimensional material is arranged in a manner extending with at least 5% of its total width beyond the width of the rolled-up layer stack substantially transversely with respect to the roll-up direction on one side, and the at least second functional layer with the at least second layer composed of a two-dimensional material or the at least second layer composed of a two-dimensional material is arranged in a manner extending with at least 5% of its total width beyond the width of the rolled-up layer stack substantially transversely with respect to the roll-up direction on the other side, and on each side of the rolled-up layer stack all functional layers extending spirally beyond with the at least one layer composed of a two-dimensional material or the at least one layer composed of a two-dimensional material are least partly cohesively connected to one another and electrically contacted.

7. Compact micro- or nanocapacitor according to Claim 6, wherein the capacitors rolled up have an external diameter of a maximum of 200 µm.

8. Compact micro- or nanocapacitor according to Claim 6, wherein graphene is present as two-dimensional material.

9. Compact micro- or nanocapacitor according to Claim 6, wherein an electrically conductive material, such as copper or nickel, is present as functional layer.

10. Compact micro- or nanocapacitor according to Claim 6, wherein Al₂O₃ or TiO₂ is present as electrically insulating material.

11. Compact micro- or nanocapacitor according to Claim 6, wherein the functional layers with the layers composed of a two-dimensional material or the layers composed of a two-dimensional material are arranged in a manner extending with at least 5 - 30% of their total width beyond the width of the rolled-up layer stack substantially transversely with respect to the roll-up direction on a respective side.

12. Compact micro- or nanocapacitor according to Claim 6, wherein a rolled-up layer stack composed of a functional layer, arranged thereabove a layer composed of a two-dimensional material, arranged thereabove a layer composed of an electrically insulating material, arranged thereabove a further functional layer, arranged thereabove a further layer composed of a two-dimensional material, arranged thereabove a further layer composed of an electrically insulating material is realized,
or a rolled-up layer stack composed of a layer composed of an electrically insulating material, arranged thereabove a functional layer, arranged thereabove a layer composed of a two-dimensional material, arranged thereabove a further layer composed of an electrically insulating material, arranged thereabove a further functional layer, arranged thereabove a further layer composed of a two-dimensional material is realized.

13. Compact micro- or nanocapacitor according to Claim 6, wherein a rolled-up layer stack composed of a layer composed of a two-dimensional material, arranged thereabove a layer composed of an electrically insulating material, arranged thereabove a further layer composed of a two-dimensional material, arranged thereabove a further layer composed of an electrically insulating material is realized,
or a rolled-up layer stack composed of a layer composed of an electrically insulating material, arranged thereabove a layer composed of a two-dimensional material, arranged thereabove a further layer composed of an electrically insulating material, arranged thereabove a further layer composed of a two-dimensional material is realized.

14. Compact micro- or nanocapacitor according to Claim 6, wherein only two functional layers with two layers composed of a two-dimensional material and two layers composed of an electrically insulating material are present, or wherein only two layers composed of a two-dimensional material and two layers composed of an electrically insulating material are present.

15. Compact micro- or nanocapacitor according to Claim 6, wherein the layers composed of the two-dimensional material are in complete cohesive contact with the functional layers and/or the layers composed of the two-dimensional material are arranged in a manner grown wholly or partly on the functional layers.

16. Compact micro- or nanocapacitor according to Claim 6, wherein the layers composed of the two-dimensional material have a thickness of ≤ 5, advantageously 1 to 2, atomic layers.

## Revendications

1. Procédé de fabrication d'un micro- ou nanocondensateur compact, selon lequel un empilement de couches est produit sur un substrat, lequel se compose séquentiellement d'au moins deux couches fonctionnelles et d'au moins une couche en un matériau bidimensionnel respectivement disposée sur celles-ci et d'au moins deux couches en un matériau électriquement isolant, lesquelles sont disposées entre les au moins deux couches fonctionnelles respectives pourvues des au moins deux couches en un matériau bidimensionnel à des fins d'isolation électrique, les couches en un matériau bidimensionnel possédant au moins partiellement un contact par fusion de matières avec les couches fonctionnelles, ou un empilement de couches composé d'au moins deux couches en un matériau bidimensionnel et d'au moins deux couches en un matériau électriquement isolant étant produit, au moins une couche en un matériau électriquement isolant étant disposée entre les au moins deux couches en un matériau bidimensionnel à des fins d'isolation électrique, et l'au moins une couche fonctionnelle pourvue de la couche en un matériau bidimensionnel ou ladite couche en un matériau bidimensionnel étant disposée sensiblement transversalement par rapport au sens de l'enroulement sur un côté en s'étendant au-delà de la largeur de l'empilement de couches, et l'au moins une deuxième couche fonctionnelle pourvue de la deuxième couche en un matériau bidimensionnel ou la deuxième couche en un matériau bidimensionnel étant disposée sensiblement transversalement par rapport au sens de l'enroulement sur l'autre côté en s'étendant au-delà de la largeur de l'empilement de couches, et l'empilement de couches étant ensuite enroulé sur le substrat et les couches qui s'étendent respectivement en forme de spirale au-delà de la largeur du composant enroulé étant au moins partiellement reliées ensemble par fusion de matières et étant mises en contact avec des bornes électriques.

2. Procédé selon la revendication 1, selon lequel l'empilement de couches est disposé tendu sur le substrat, le gradient de tension de l'empilement de couches étant avantageusement orienté perpendiculairement à la surface du substrat et l'empilement de couches étant ensuite enroulé.

3. Procédé selon la revendication 1, selon lequel une couche sacrificielle est appliquée sur le substrat et l'empilement de couches est ensuite disposé sur la couche sacrificielle et la couche sacrificielle est ensuite au moins partiellement enlevée.

4. Procédé selon la revendication 1, selon lequel l'enroulement de l'empilement de couches est effectué dans un liquide, de préférence dans un liquide à base d'eau ou une solution aqueuse ou un solvant ou un mélange de solvants, et l'empilement de couches enroulé est ensuite séché, le séchage de l'empilement de couches enroulé étant de préférence effectué à des températures de 15 °C à 400 °C.

5. Procédé selon la revendication 1, selon lequel les matériaux bidimensionnels mis en contact ensemble étant mis en contact avec les bornes électriques avec du nickel ou du cuivre.

6. Micro- ou nanocondensateur compact, fabriqué d'après un procédé selon la revendication 1, lequel se compose d'au moins deux couches fonctionnelles chacune pourvue d'au moins une couche en un matériau bidimensionnel, lesquelles possèdent au moins partiellement un contact par fusion de matières avec les couches fonctionnelles, et d'au moins deux couches en un matériau électriquement isolant ou d'au moins deux couches en un matériau bidimensionnel et d'au moins deux couches en un matériau électriquement isolant, les couches fonctionnelles pourvues des couches en un matériau bidimensionnel ou les couches en un matériau bidimensionnel étant disposées séparément les unes des autres respectivement de manière isolée électriquement par les couches en un matériau électriquement isolant, et ces couches disposées les unes au-dessus des autres étant enroulées et l'au moins une couche fonctionnelle pourvue de l'au moins une couche en un matériau bidimensionnel ou l'au moins une couche en un matériau bidimensionnel étant disposée sensiblement transversalement par rapport au sens de l'enroulement sur un côté en s'étendant avec au moins 5 % de sa largeur totale au-delà de la largeur de l'empilement de couches enroulé, et l'au moins une deuxième couche fonctionnelle pourvue de l'au moins une deuxième couche en un matériau bidimensionnel ou l'au moins une deuxième couche en un matériau bidimensionnel étant disposée sensiblement transversalement par rapport au sens de l'enroulement sur l'autre côté en s'étendant avec au moins 5 % de sa largeur totale au-delà de la largeur de l'empilement de couches enroulé, et de chaque côté de l'empilement de couches enroulé, toutes les couches fonctionnelles qui s'étendent en forme de spirale pourvues de l'au moins une deuxième couche en un matériau bidimensionnel ou l'au moins une couche en un matériau bidimensionnel étant au moins partiellement reliées ensemble par fusion de matières et mises en contact électrique.

7. Micro- ou nanocondensateur compact selon la revendication 6, avec lequel les condensateurs enroulés possèdent un diamètre extérieur maximal de 200 µm.

8. Micro- ou nanocondensateur compact selon la revendication 6, avec lequel le matériau bidimensionnel présent est du graphène.

9. Micro- ou nanocondensateur compact selon la revendication 6, avec lequel la couche fonctionnelle présente est un matériau électriquement conducteur comme du cuivre ou du nickel.

10. Micro- ou nanocondensateur compact selon la revendication 6, avec lequel le matériau électriquement isolant présent est de l'Al₂O ou du TiO₂.

11. Micro- ou nanocondensateur compact selon la revendication 6, avec lequel les couches fonctionnelles pourvues des couches en un matériau bidimensionnel ou les couches en un matériau bidimensionnel sont disposées sensiblement transversalement par rapport au sens de l'enroulement en s'étendant respectivement sur un côté avec au moins 5 à 30 % de leur largeur totale au-delà de la largeur de l'empilement de couches enroulé.

12. Micro- ou nanocondensateur compact selon la revendication 6, avec lequel un empilement de couches enroulé est réalisé à partir d'une couche fonctionnelle, d'une couche en un matériau bidimensionnel disposée au-dessus de celle-ci, d'une couche en un matériau électriquement isolant disposée au-dessus de celle-ci, d'une couche fonctionnelle supplémentaire disposée au-dessus de celle-ci, d'une couche supplémentaire en un matériau bidimensionnel disposée au-dessus de celle-ci, d'une couche supplémentaire en un matériau électriquement isolant disposée au-dessus de celle-ci,
ou un empilement de couches enroulé est réalisé à partir d'une couche en un matériau électriquement isolant, d'une couche fonctionnelle disposée au-dessus de celle-ci, d'une couche en un matériau bidimensionnel disposée au-dessus de celle-ci, d'une couche supplémentaire en un matériau électriquement isolant disposée au-dessus de celle-ci, d'une couche fonctionnelle supplémentaire disposée au-dessus de celle-ci, d'une couche supplémentaire en un matériau bidimensionnel disposée au-dessus de celle-ci.

13. Micro- ou nanocondensateur compact selon la revendication 6, avec lequel un empilement de couches enroulé est réalisé à partir d'une couche en un matériau bidimensionnel, d'une couche en un matériau électriquement isolant disposée au-dessus de celle-ci, d'une couche supplémentaire en un matériau bidimensionnel disposée au-dessus de celle-ci, d'une couche supplémentaire en un matériau électriquement isolant disposée au-dessus de celle-ci,
ou un empilement de couches enroulé est réalisé à partir d'une couche en un matériau électriquement isolant, d'une couche en un matériau bidimensionnel disposée au-dessus de celle-ci, d'une couche supplémentaire en un matériau électriquement isolant disposée au-dessus de celle-ci, d'une couche supplémentaire en un matériau bidimensionnel disposée au-dessus de celle-ci.

14. Micro- ou nanocondensateur compact selon la revendication 6, avec lequel seules deux couches fonctionnelles pourvues de deux couches en un matériau bidimensionnel et deux couches en un matériau électriquement isolant sont présentes, ou avec lequel seules deux couches en un matériau bidimensionnel et deux couches en un matériau électriquement isolant sont présentes.

15. Micro- ou nanocondensateur compact selon la revendication 6, avec lequel les couches en le matériau bidimensionnel se trouvent en contact complet par fusion de matières avec les couches fonctionnelles et/ou les couches en le matériau bidimensionnel sont disposées par épitaxie totale ou partielle sur les couches fonctionnelles.

16. Micro- ou nanocondensateur compact selon la revendication 6, avec lequel les couches en le matériau bidimensionnel possèdent une épaisseur ≤ 5, de préférence 1 à 2 couches atomiques.
